# EUROPEAN PATENT SPECIFICATION

(11) **EP 4 346 032 B1**
(45) Date of publication and mention of the grant of the patent: **16.04.2025**
(21) Application number: 23198776.9
(22) Date of filing: 21.09.2023
(51) Int. Cl.: H01S 5/00, H01L 33/50

(54) **LIGHT-EMITTING DEVICE**
LICHTEMITTIERENDE VORRICHTUNG
DISPOSITIF ÉLECTROLUMINESCENT

(30) Priority: 29.09.2022 JP 2022157195
(43) Date of publication of application: 03.04.2024
(73) Proprietor: Nichia Corporation, Anan-shi, Tokushima 774-8601 (JP)
(72) Inventor: MIURA, Soichiro, Tokushima, 774-8601Tokushima 774-8601 (JP)
(74) Representative: Betten & Resch

(56) References cited:
- JP-A- 2007 005 483
- US-A1- 2013 329 397
- US-A1- 2022 231 479
- US-B2- 9 528 684

## Description

### BACKGROUND

The present disclosure relates to a light-emitting device.

Japanese Patent Publication No. 2019-53130 discloses a light-emitting device including: a semiconductor laser element; a reflective body configured to reflect upward light emitted from the semiconductor laser element; a light-transmissive body through which the light reflected by the reflective body passes; and a wavelength conversion member on which the light emitted from the light-transmissive body is incident.

JP 2007-005483 A addresses the problem of how to provide a semiconductor light emitting device capable of outputting high brightness and also using safely excitation light of high energy. As solution, it is suggested: A semiconductor light emitting device is provided with a semiconductor light emitting element which irradiates light in the range from ultraviolet ray to visible light; and a phosphor which absorbs all the lights irradiated from the semiconductor light emitting element and outputs visible light in a light extracting direction different from a light irradiating direction of the semiconductor light emitting element based on the absorbed light. Accordingly, the light irradiated from the semiconductor light emitting elements not directly outputted in the light extraction direction.

### SUMMARY

The invention is defined by the independent claim. Dependent claims specify embodiments thereof.

The present disclosure realizes a light-emitting device that includes a semiconductor laser element and a wavelength conversion member, and can be produced at a lower cost.

Alternatively or additionally to the above, the present disclosure realizes a light-emitting device that includes a semiconductor laser element and a wavelength conversion member, and includes a smaller number of parts that constitute the light-emitting device.

Alternatively or additionally to the above, the present disclosure realizes a light-emitting device that includes a semiconductor laser element and a wavelength conversion member, and can be produced by a simpler production process.

A light-emitting device disclosed in one embodiment includes a semiconductor laser element, a wavelength conversion member, and a package. The wavelength conversion member includes a wavelength conversion portion and a reflective portion. The wavelength conversion portion includes: a light incident surface that is a lateral surface on which light emitted from the semiconductor laser element is incident, and a light-emitting surface that is an upper surface from which light converted in wavelength is emitted, the light converted in wavelength being obtained by converting a wavelength of the light emitted from the semiconductor laser element. The reflective portion is provided on a surface of the wavelength conversion portion that does not include the light incident surface and does not include the light-emitting surface. The reflective portion is configured to reflect: the light emitted from the semiconductor laser element and incident on the wavelength conversion portion, and the light converted in wavelength by the wavelength conversion portion. The package includes a disposition region where the semiconductor laser element and the wavelength conversion member are disposed, and defines an inner space in which the semiconductor laser element and the wavelength conversion member are disposed. The wavelength conversion member is disposed at a position away in a first direction from a position at which the semiconductor laser element is disposed. In a plan view perpendicular to the light-emitting surface, the light-emitting surface has a shape that has a first region increasing in width in a second direction perpendicular to the first direction from a side closest to the semiconductor laser element toward the first direction. In the plan view perpendicular to the light-emitting surface, a region of at least 80% or more of the light incident surface overlaps an imaginary line that passes through a point of the light-emitting surface closest to the semiconductor laser element and that is parallel to the second direction.

According to at least one embodiment disclosed herein, the above-described light-emitting device is realized.

### BRIEF DESCRIPTION OF DRAWINGS

FIG. 1 is a perspective view of a light-emitting device according to embodiments;
FIG. 2 is a cross-sectional view of FIG. 1 taken along cross-sectional line II-II;
FIG. 3A is a perspective view, from above, of a wavelength conversion member of a first example according to the embodiments;
FIG. 3B illustrates six-face views of the wavelength conversion member of the first example according to the embodiments;
FIG. 3C is a perspective view, from above, of the light-emitting device including the wavelength conversion member of the first example according to the embodiments;
FIG. 3D illustrates six-face views of the light-emitting device including the wavelength conversion member of the first example according to the embodiments;
FIG. 4A is a perspective view, from above, of a wavelength conversion member of a second example according to the embodiments;
FIG. 4B illustrates six-face views of the wavelength conversion member of the second example according to the embodiments;
FIG. 4C is a perspective view, from above, of the light-emitting device including the wavelength conversion member of the second example according to the embodiments;
FIG. 4D illustrates six-face views of the light-emitting device including the wavelength conversion member of the second example according to the embodiments;
FIG. 5A is a perspective view, from above, of a wavelength conversion member of a third example according to the embodiments;
FIG. 5B illustrates six-face views of the wavelength conversion member of the third example according to the embodiments;
FIG. 5C is a perspective view, from above, of the light-emitting device including the wavelength conversion member of the third example according to the embodiments;
FIG. 5D illustrates six-face views of the light-emitting device including the wavelength conversion member of the third example according to the embodiments;
FIG. 6A is a perspective view, from above, of a wavelength conversion member of a fourth example according to the embodiments, which is not covered by the claims but helpful for understanding the invention;
FIG. 6B illustrates six-face views of the wavelength conversion member of the fourth example according to the embodiments;
FIG. 6C is a perspective view, from above, of the light-emitting device including the wavelength conversion member of the fourth example according to the embodiments;
FIG. 6D illustrates six-face views of the light-emitting device including the wavelength conversion member of the fourth example according to the embodiments;
FIG. 7A is a perspective view, from above, of a wavelength conversion member of a fifth example according to the embodiments, which is not covered by the claims but helpful for understanding the invention;
FIG. 7B illustrates six-face views of the wavelength conversion member of the fifth example according to the embodiments;
FIG. 7C is a perspective view, from above, of the light-emitting device including the wavelength conversion member of the fifth example according to the embodiments;
FIG. 7D illustrates six-face views of the light-emitting device including the wavelength conversion member of the fifth example according to the embodiments;
FIG. 8A is a perspective view, from above, of a wavelength conversion member of a sixth example according to the embodiments, which is not covered by the claims but helpful for understanding the invention;
FIG. 8B illustrates six-face views of the wavelength conversion member of the sixth example according to the embodiments;
FIG. 8C is a perspective view, from above, of the light-emitting device including the wavelength conversion member of the sixth example according to the embodiments;
FIG. 8D illustrates six-face views of the light-emitting device including the wavelength conversion member of the sixth example according to the embodiments;
FIG. 9A is a perspective view, from above, of a wavelength conversion member of a seventh example according to the embodiments, which is not covered by the claims but helpful for understanding the invention;
FIG. 9B illustrates six-face views of the wavelength conversion member of the seventh example according to the embodiments;
FIG. 9C is a perspective view, from above, of the light-emitting device including the wavelength conversion member of the seventh example according to the embodiments; and
FIG. 9D illustrates six-face views of the light-emitting device including the wavelength conversion member of the seventh example according to the embodiments.

### DETAILED DESCRIPTION

In the present specification and the claims, as for polygons such as triangles and quadrangles, polygons with rounded corners, beveled corners, angled corners, reverse-rounded corners are also referred to as polygons. Likewise, not only shapes with such modification at corners (end of sides) but also shapes with modifications at intermediate portions of sides of the shapes are also referred to as polygons. That is, shapes based on polygons with partial modification are also interpreted as "polygons" in the present specification and the claims.

Such interpretation is applied not only to polygons but also applies to terms denoting specific shapes such as trapezoids, circles, projections, and recesses. The same applies to sides forming such shapes. That is, even if an end or an intermediate portion of a side is modified, the modified portion is interpreted as a portion of a "side." When "polygons" and "sides" without such modified portions are intended to be distinguished from those with modifications, the term "exact" is added, such as an "exact quadrangle."

Also, in the present specification and the claims, such terms as "top and bottom (above/below)," "left and right," "front face and rear face," "back and forth (backward/forward)," and "front and back" just describe relative relationships of, for example, positions, orientations, and directions, and do not necessarily match actual relationships in use.

Also, in the drawings, directions such as an X direction, a Y direction, and a Z direction may be indicated by arrows. Directions of these arrows are consistent between a plurality of drawings according to the same embodiment. Also, in the drawings, the directions indicated by the arrows with X, Y, and Z are positive directions, and the opposite directions thereto are negative directions. For example, the direction indicated by the arrow with X at the tip thereof is the X direction and the positive direction. Note that a direction that is the X direction and the positive direction is referred to as a "positive X-direction," and the opposite direction thereto is referred to as a "negative X-direction." The same applies to the Y direction and Z direction.

Also, in the present specification, the terms "member" and "portion" may be used, for example, when components are described. The term "member" refers to an object that is physically treated as a single body. The object that is physically treated as a single body can also be an object that is treated as a single part in a production process. Meanwhile, the term "portion" refers to an object that is not necessarily physically treated as a single body. For example, the term "portion" is used, for example, when a part of a single member is treated or when a plurality of members is collectively treated as a single object.

Note that use of the above different terms, "member" and "portion", is not intended to limit the claimed scope under the doctrine of equivalents. Specifically, even if there is a component expressed by the term "member" in the claims, the applicant does not necessarily imply only from the use of this term that it is indispensable that this component is physically treated as a single body in the application of the present invention.

Also, in the present specification and the claims, when there are a plurality of certain components and these components are distinguishably expressed, the terms "first" and "second" may be added before those components for distinction. Also, there may be a case in which an object distinguished is different between in the present specification and in the claims. Therefore, even if the claims describe a component having the same labelling term as in the present specification, an object that is specified by this component is not necessarily the same between in the present specification and in the claims.

For example, when the present specification describes components distinguished with "first," "second," and "third," and the components with "first" and "third" in the present specification are described in the claims, those components may be labelled with "first" and "second" in the claims from the viewpoint of readability. In this case, the components with "first" and "second" in the claims respectively refer to the components with "first" and "third" in the present specification. Note that this rule is not only applied to components but also applied to other objects reasonably and flexibly.

Hereinafter, embodiments of the present invention will be described. In more detail, referring to the drawings, specific embodiments of the present invention will also be described. Note that the embodiments of the present invention are not limited to those specific embodiments of the present invention. In other words, the embodiments of the present invention are not only the embodiments that are illustrated in the drawings. Note that the sizes, positional relationships, etc. of the members illustrated in the drawings may be emphasized for the ease of understanding.

### <Embodiments>

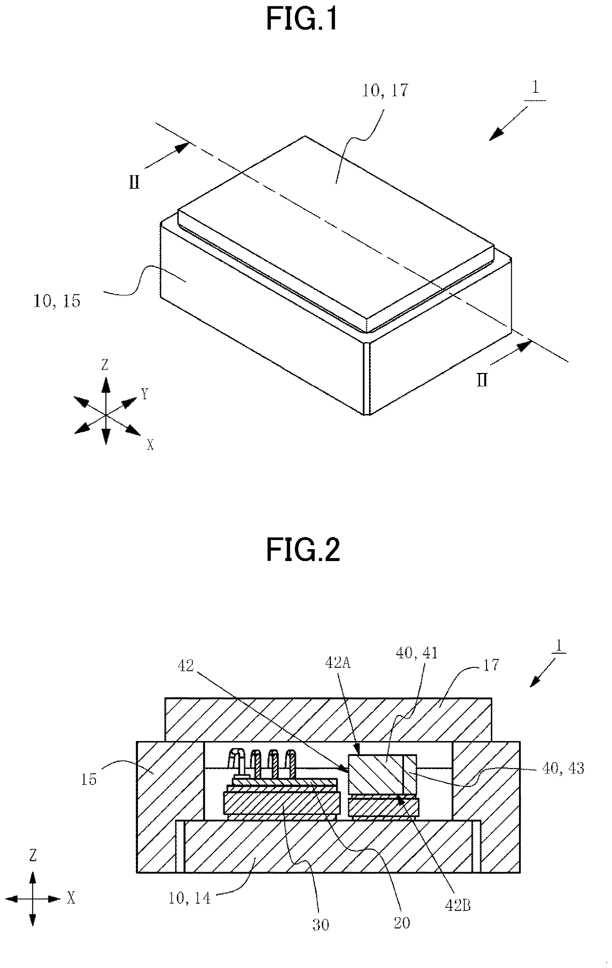

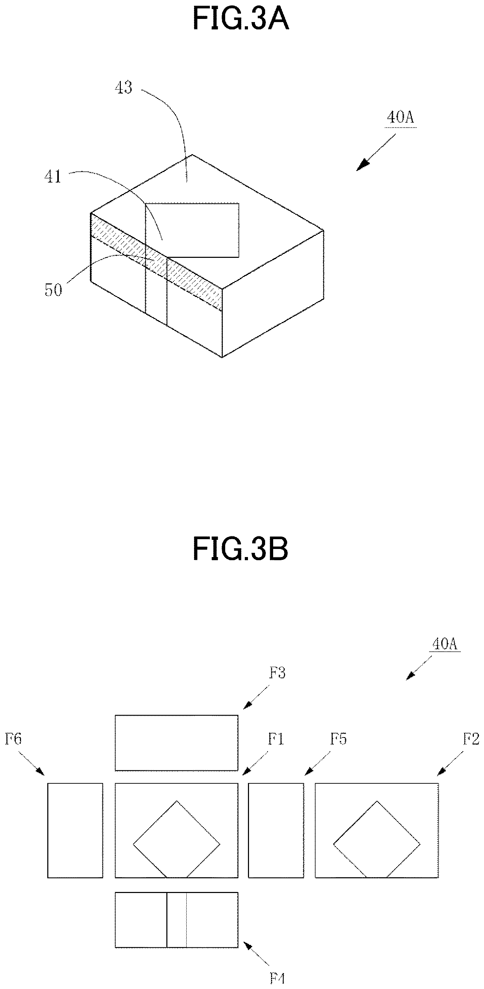

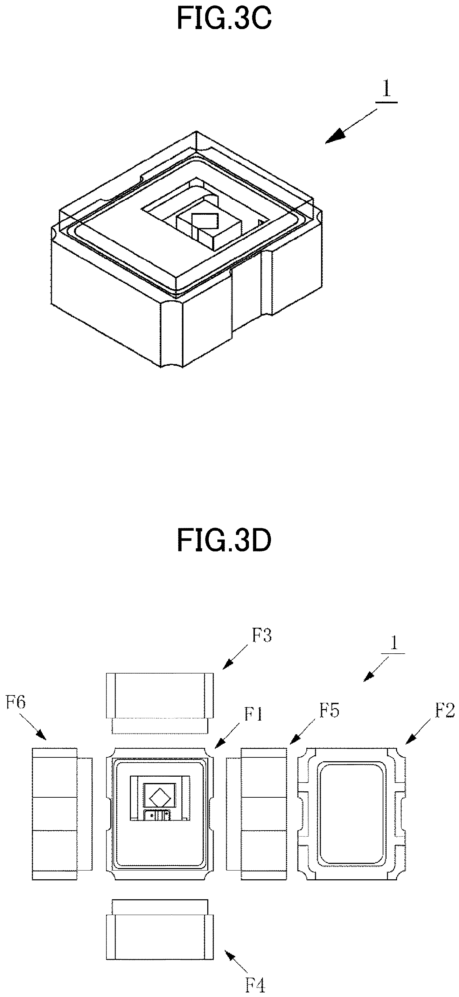

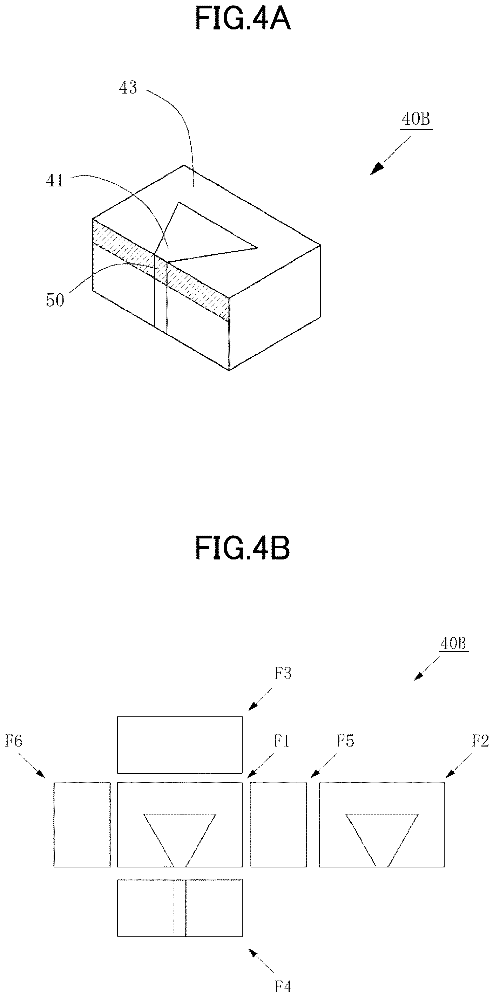

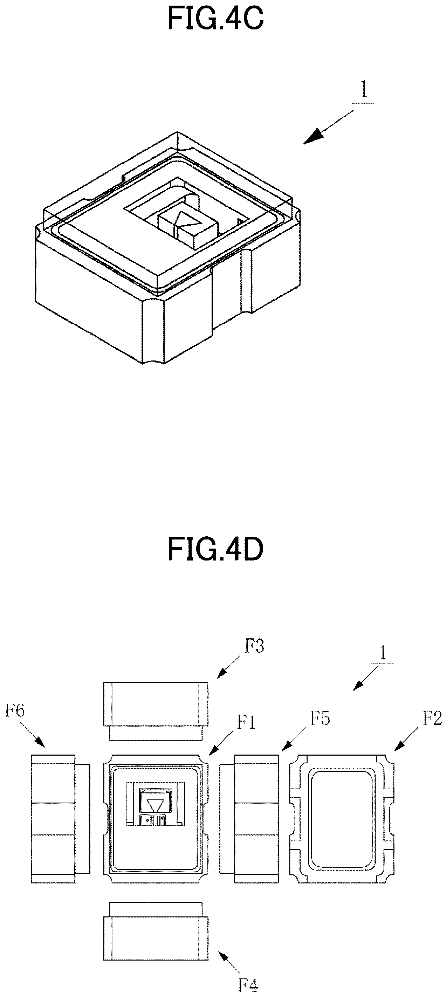

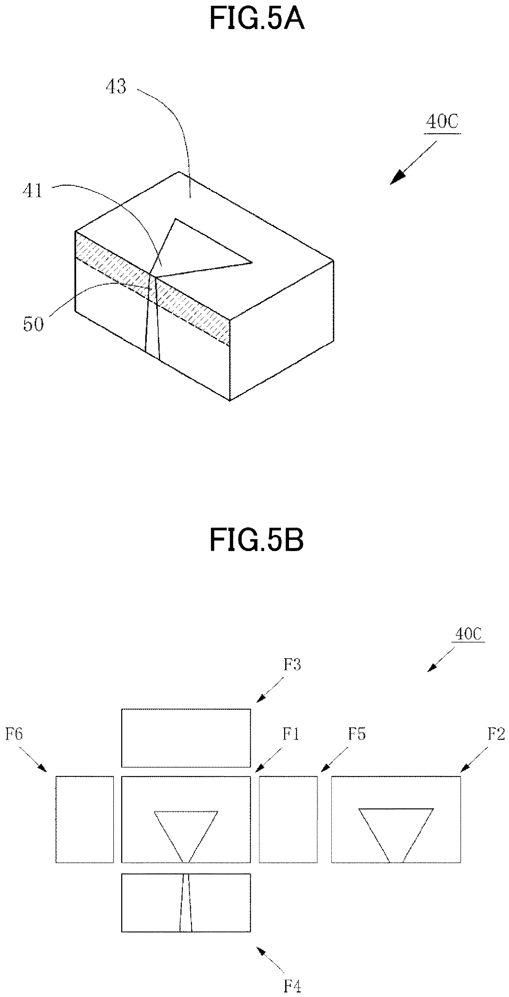

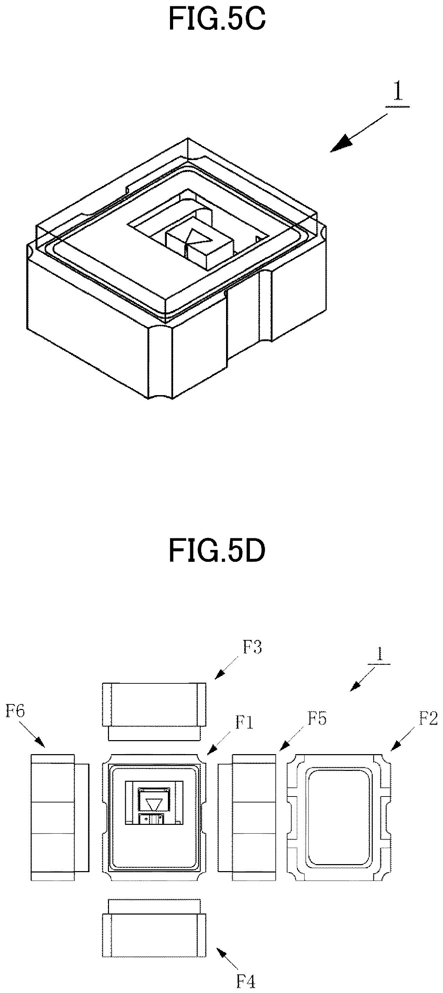

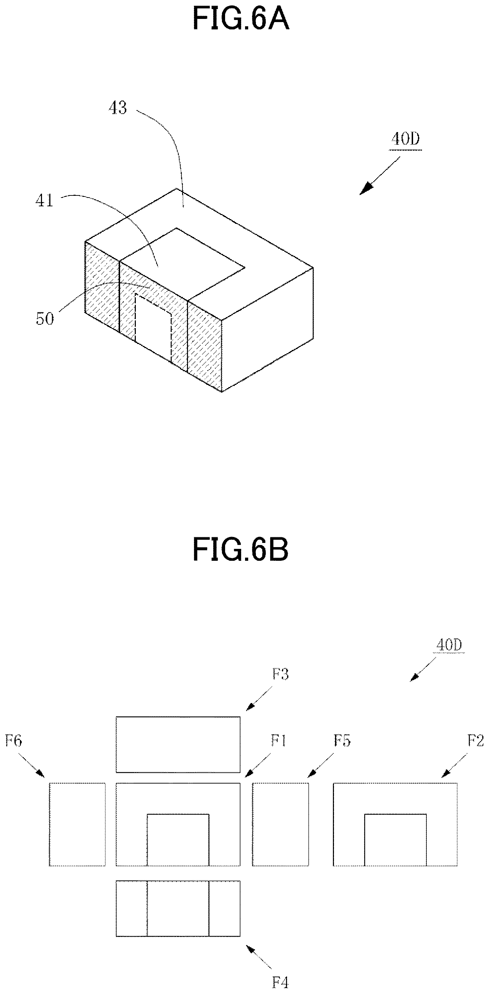

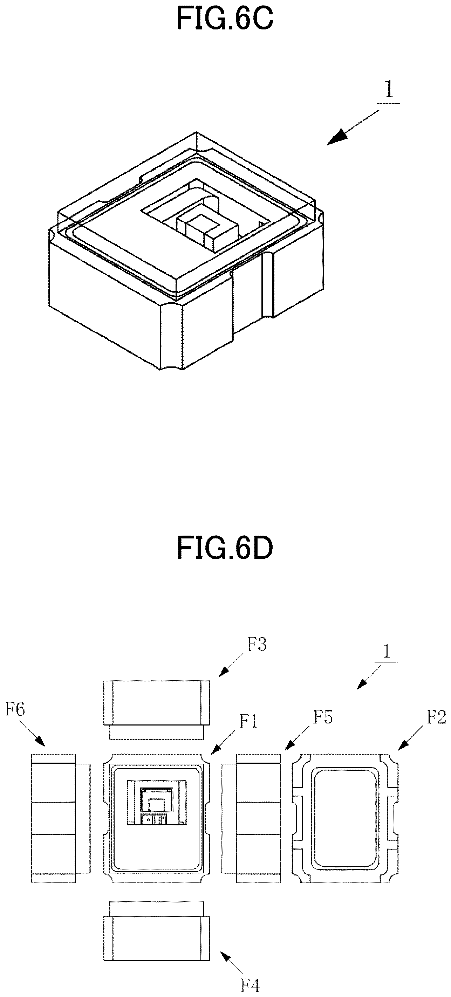

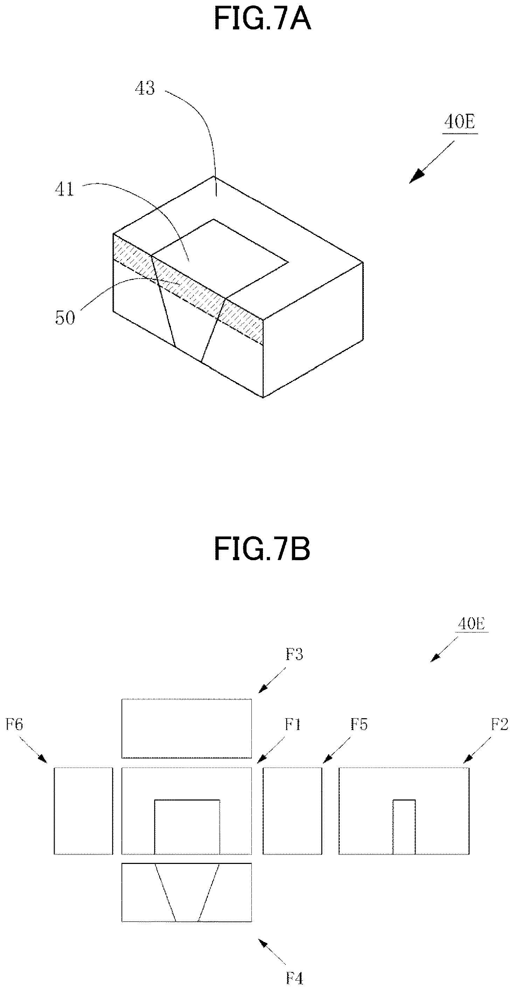

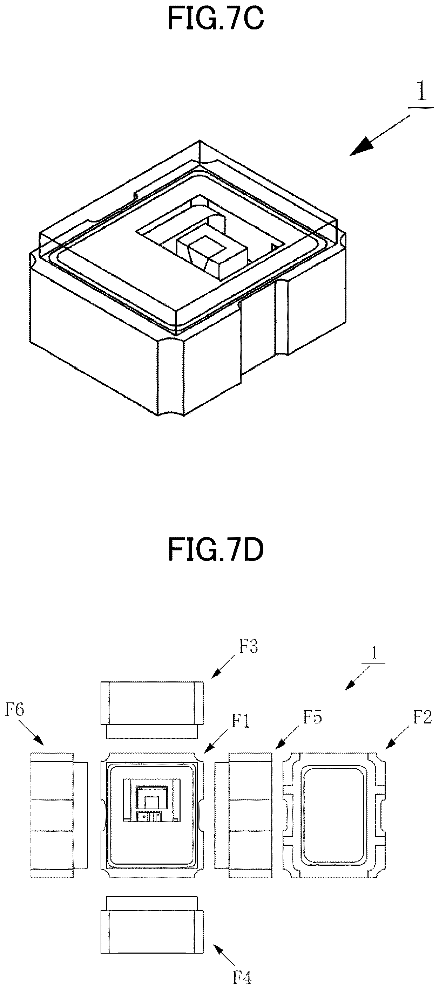

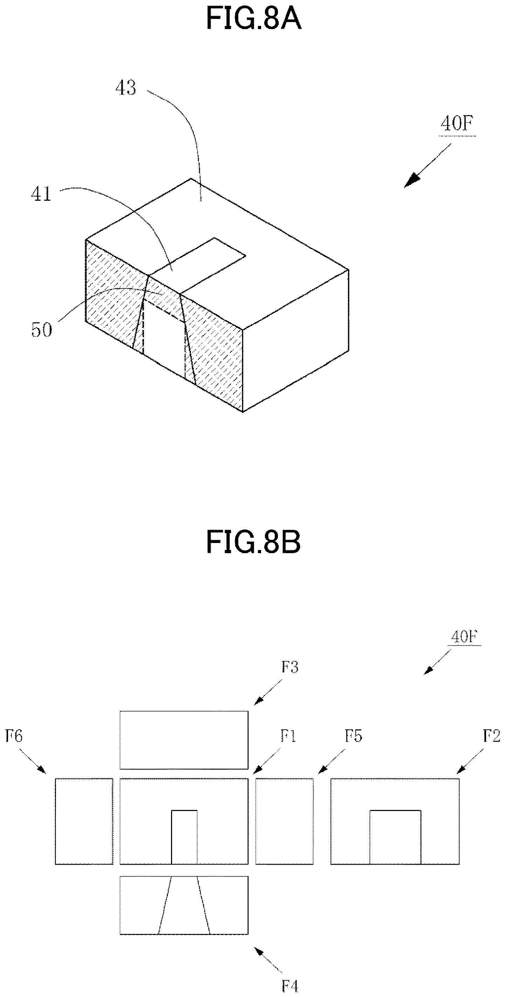

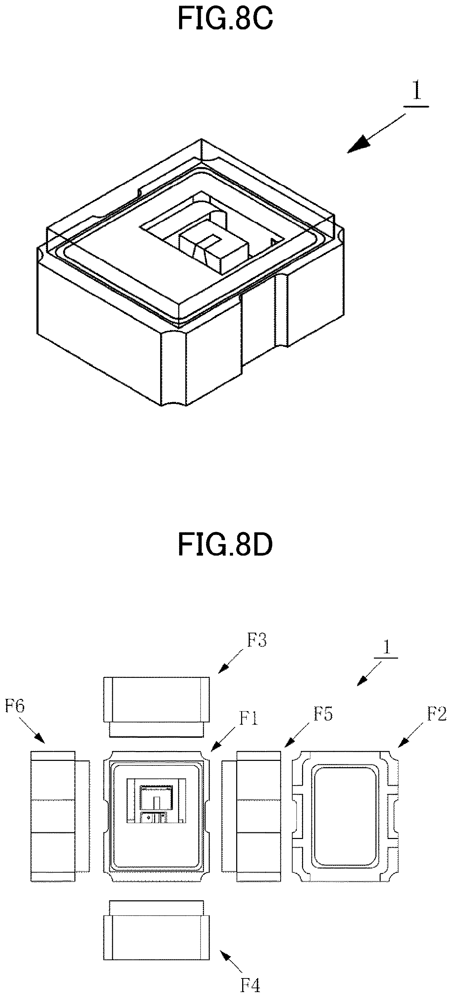

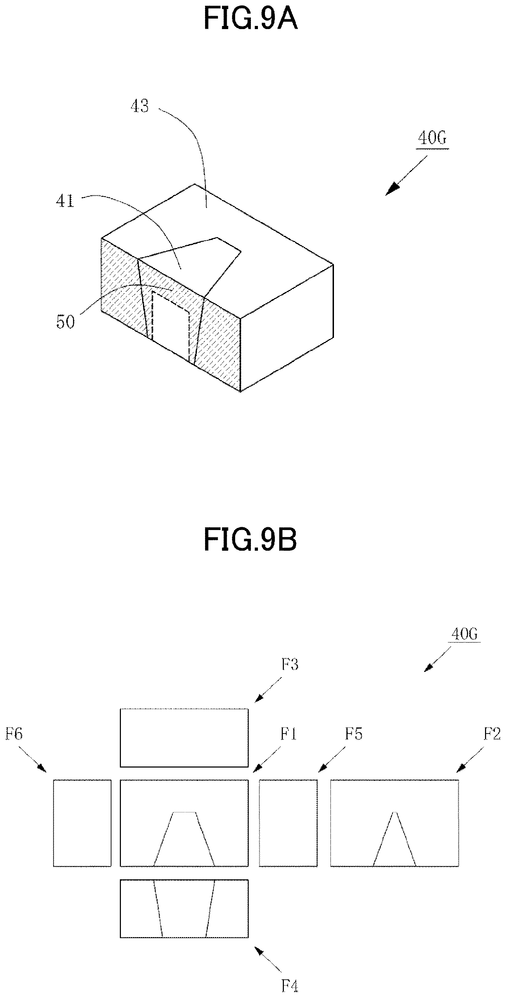

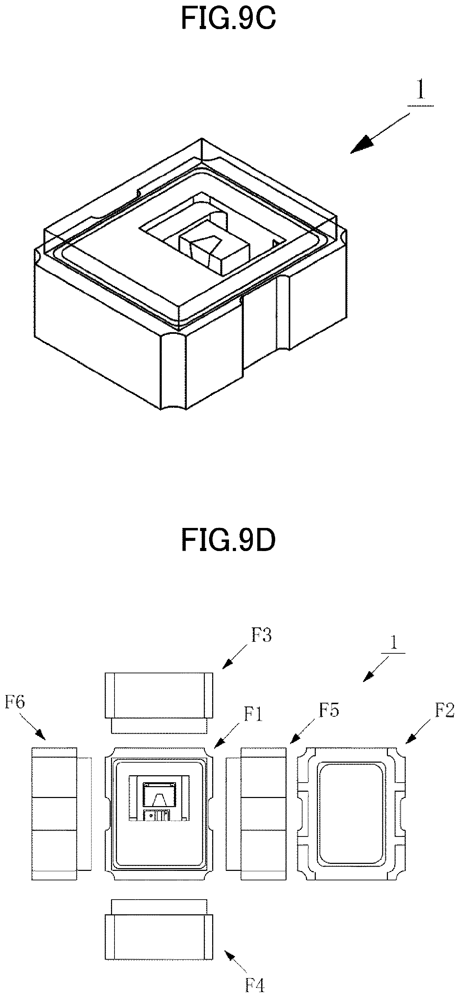

Light-emitting devices 1 according to the embodiments will be described. FIG. 1 to FIG. 15D are drawings each depicting one exemplary form of the light-emitting devices 1. FIG. 1 is a perspective view of the light-emitting device 1. FIG. 2 is a cross-sectional view of FIG. 1 taken along cross-sectional line II-II. FIG. 3A to FIG. 3D are drawings depicting the light-emitting device 1 including a wavelength conversion member 40A, which is the first example of a wavelength conversion member 40. FIG. 4A to FIG. 4D are drawings depicting the light-emitting device 1 including a wavelength conversion member 40B, which is the second example of the wavelength conversion member 40. FIG. 5A to FIG. 5D are drawings depicting the light-emitting device 1 including a wavelength conversion member 40C, which is the third example of the wavelength conversion member 40. FIG. 6A to FIG. 6D are drawings depicting the light-emitting device 1 including a wavelength conversion member 40D, which is the fourth example of the wavelength conversion member 40. FIG. 7A to FIG. 7D are drawings depicting the light-emitting device 1 including a wavelength conversion member 40E, which is the fifth example of the wavelength conversion member 40. FIG. 8A to FIG. 8D are drawings depicting the light-emitting device 1 including a wavelength conversion member 40F, which is the sixth example of the wavelength conversion member 40. FIG. 9A to FIG. 9D are drawings depicting the light-emitting device 1 including a wavelength conversion member 40G, which is the seventh example of the wavelength conversion member 40. Note that, except for FIG. 1, the light-emitting device 1 is illustrated in a state of being seeable through the surface of a cover portion 17 including a light transmissive portion and a light-shielding film. Also, the six-face views are not the same as the actual sizes, and are illustrated without emphasizing differences in size and positional relationships between the members. Also, the six-face views are a front view indicated by arrow F1, a rear view indicated by arrow F2, a plan view indicated by arrow F3, a bottom view indicated by arrow F4, a right-hand side view indicated by arrow F5, and a lefthand side view indicated by arrow F6.

The light-emitting device 1 includes a plurality of components. The plurality of components includes a package 10, a semiconductor laser element 20, a submount 30, the wavelength conversion member 40, and a reflective film 50. Note that the light-emitting device 1 may further include other components. Also, the light-emitting device 1 may not include some of the plurality of components described above.

First, each of the components will be described.

### (Package 10)

The package 10 includes a base portion 14, a frame portion 15, and the cover portion 17. The package 10 includes, for example, a base member constituting the base portion 14 and the frame portion 15, and a cover member constituting the cover portion 17. Note that the base member may be formed by bonding a mounted member constituting the base portion 14 to a frame member constituting the frame portion 15. Alternatively, the package 10 may include a base member constituting the base portion 14, and a cover member constituting the frame portion 15 and the cover portion 17.

The package 10 includes a closed space in the interior thereof. This inner space (closed space formed in the interior) is a sealed space. Also, this inner space is a space that is hermetically sealed in a predetermined atmosphere.

The package 10 includes a disposition region where other components are disposed. The disposition region is provided on the upper surface of the package 10. Although the disposition region is not necessarily provided on the same plane, the disposition region is provided on planes facing toward the same direction (here, on planes facing upward).

A main material of the mounted member is, for example, a metal or a metal-containing composite. For example, the main material of the mounted member is copper. Also, a main material of the frame member is, for example, a ceramic. For example, the main material of the frame member is aluminum nitride, silicon nitride, or aluminum oxide. Also, a main material of the cover member is, for example, quartz, silicon carbide, sapphire, or glass. Note that, when the base portion 14 and the frame portion 15 are integrally formed using the same material, the main material of the base member is a ceramic.

As used herein, the main material refers to a material that has the highest weight or volume percentage in a formed product of interest. Note that, when the formed product of interest is formed from one material, that material is the main material. That is, the fact that a certain material is the main material includes a case in which the percentage of that material can be 100%.

### (Semiconductor laser element 20)

The semiconductor laser element 20 has emission end surfaces that emit light. The semiconductor laser element 20 has an upper surface, a lower surface, and a plurality of lateral surfaces. The lateral surfaces of the semiconductor laser element 20 become the emission end surfaces. The outer shape of the semiconductor laser element 20 in a top view is a rectangular shape having long sides and short sides. This outer shape is not necessarily such a rectangular shape.

The semiconductor laser element 20 to be used can be, for example, a semiconductor laser element that emits blue light. As used herein, the blue light refers to light having a light emission peak within the range of 420 nm to 494 nm. Note that the semiconductor laser element 20 to be used may be a semiconductor laser element that emits light of another color. The semiconductor laser element 20 to be used may be a semiconductor laser that emits light having a light emission peak within the range of 320 nm to 530 nm.

The semiconductor laser element 20 is, for example, a semiconductor laser element containing a nitride semiconductor. As the nitride semiconductor, for example, GaN, InGaN, and AlGaN can be used.

Here, the light emitted from the semiconductor laser element will be described. The light emitted from the semiconductor laser element (laser beam) exhibits divergence. The light emitted from the semiconductor laser element forms an elliptic far-field pattern (hereinafter referred to as "FFP") in a plane parallel to the emission end surface of the light. The FFP indicates the shape or light intensity distribution of emitted light at a position away from the emission end surface.

Here, light passing through the center of the elliptic shape of the FFP, in other words, light having a peak intensity in the light intensity distribution of the FFP, is referred to as light traveling along an optical axis or light lying along an optical axis. Also, light having an intensity of 1/e² or more of the peak intensity in the light intensity distribution of the FFP is referred to as a main portion of the light.

The shape of the FFP of the light emitted from the semiconductor laser element is an elliptic shape that is longer in a stacking direction than in a direction perpendicular to the stacking direction in the plane parallel to the emission end surface of the light. The stacking direction refers to a direction in which a plurality of semiconductor layers including an active layer are stacked in the semiconductor laser element. The direction perpendicular to the stacking direction can also be referred to as a plane direction of the semiconductor layers. Further, a direction along the major axis of the elliptic shape of the FFP can also be referred to as a fast axis direction of the semiconductor laser element, and a direction along the minor axis of the elliptic shape of the FFP can also be referred to as a slow axis direction of the semiconductor laser element.

On the basis of the light intensity distribution of the FFP, an angle at which light having a light intensity of 1/e² of the peak light intensity diverges is referred to as an angle of divergence of the light of the semiconductor laser element. The angle of divergence may be determined from, for example, a light intensity half the peak light intensity, as well as from the light intensity of 1/e² of the peak light intensity. In the description of the present specification, the term "angle of divergence" refers to the angle of divergence of the light at a light intensity of 1/e² of the peak light intensity. Note that the angle of divergence in the fast axis direction is larger than the angle of divergence in the slow axis direction.

As the semiconductor laser element 20, for example, it is possible to use a semiconductor laser element having an angle of divergence in the slow axis direction of 2 degrees to 30 degrees. As the semiconductor laser element 20, for example, it is possible to use a semiconductor laser element having an angle of divergence in the fast axis direction of 5 degrees to 120 degrees.

### (Submount 30)

The submount 30 has an upper surface and a lower surface. The submount 30 is formed in a rectangular parallelepiped shape. The submount 30 has, in a top view, a rectangular outer shape having long sides and short sides. The width of the submount 30 is the smallest in the up-and-down direction. The width of the submount 30 in the up-and-down direction can be 50 µm or more and 1000 µm or less. Note that the shape of the submount 30 is not limited to a rectangular parallelepiped shape. The submount 30 can be formed using, for example, silicon nitride, aluminum nitride, or silicon carbide.

### (Wavelength conversion member 40)

The wavelength conversion member 40 includes a wavelength conversion portion 41 and a reflective portion 43. In the wavelength conversion member 40, the surface of a part of the wavelength conversion portion 41 is covered with the reflective portion 43, and the surface of the other part thereof is not covered with the reflective portion 43. The shape of the outer edge of the upper surface of the wavelength conversion member 40 is a quadrangle.

The wavelength conversion portion 41 has an upper surface 42A, a lower surface 42B, and one or more lateral surfaces 42. In the wavelength conversion member 40, the upper surface 42A of the wavelength conversion portion 41 is not covered with the reflective portion 43. In the wavelength conversion member 40, a part of the one or more lateral surfaces 42 is covered with the reflective portion 43, and the other part thereof is not covered with the reflective portion 43. The part of the one or more lateral surfaces 42 covered with the reflective portion 43 contacts the reflective portion 43.

The wavelength conversion portion 41 includes a light incident surface and a light-emitting surface. In the wavelength conversion portion 41, a region of the one or more lateral surfaces 42 that is not covered with the reflective portion 43 can be the light incident surface. In the wavelength conversion portion 41, a region of the upper surface 42A that is not covered with the reflective portion 43 can be the light-emitting surface. The reflective portion 43 is provided on a surface of the wavelength conversion portion 41 that does not include the light incident surface and the light-emitting surface.

For example, the one lateral surface 42 not covered with the reflective portion 43 in the entirety thereof can be the light incident surface. Also, for example, an uncovered region of the one lateral surface 42 that is partially covered with the reflective portion 43 can be the light incident surface. Also, for example, one region that is formed by selectively combining these lateral surfaces 42 and is not covered with the reflective portion 43 can be the light incident surface.

The lower surface 42B of the wavelength conversion portion 41 is not covered with the reflective portion 43. Note that the lower surface 42B may be covered with the reflective portion 43.

In the wavelength conversion portion 41, a region of the one or more lateral surfaces 42 that is located opposite to the light incident surface is covered with the reflective portion 43. In the wavelength conversion portion 41, a region of the one or more lateral surfaces 42 that is continuous from the light incident surface is covered with the reflective portion 43. In the wavelength conversion portion 41, all of the one or more lateral surfaces 42 that intersect the light incident surface are covered with the reflective portion 43. In the wavelength conversion portion 41, the entire region of the one or more lateral surfaces 42 that is other than the light incident surface is covered with the reflective portion 43.

On the surface of the wavelength conversion member 40, the light incident surface and the light-emitting surface connect to each other. In other words, on the surface of the wavelength conversion member 40, the light incident surface and the light-emitting surface are directly connected.

In a plan view perpendicular to the light-emitting surface of the wavelength conversion portion 41, the reflective portion 43 surrounds the entire periphery of the light-emitting surface excluding the portion connected between the light incident surface and the light-emitting surface. The reflective portion 43 has a lateral surface that is flush with the light incident surface of the wavelength conversion portion 41 and extends laterally. Note that, as used herein, the term "laterally" means the same direction as the Y direction in the light-emitting device 1 as illustrated.

The wavelength conversion portion 41 contains a phosphor. Examples of the phosphor include cerium-activated yttrium-aluminum-garnet (YAG), cerium-activated lutetium-aluminum-garnet (LAG), europium-activated silicate ((Sr,Ba)₂SiO₄), α-SiAlON phosphors, and β-SiAlON phosphors. Among these phosphors, YAG phosphors have good heat resistance.

The wavelength conversion portion 41 is preferably formed using, as the main material, an inorganic material that is readily decomposed by irradiation with light. The main material of the wavelength conversion portion 41 is, for example, a ceramic. Note that the main material is not limited to the ceramic. Also, the wavelength conversion portion 41 may be formed of a single crystal of the phosphor. Examples of the ceramic include aluminum oxide, aluminum nitride, silicon oxide, yttrium oxide, zirconium oxide, and magnesium oxide.

The wavelength conversion portion 41 is formed using, for example, a ceramic as the main material. Also, for example, the wavelength conversion portion 41 is a sintered body. The wavelength conversion portion 41 can be formed by sintering, for example, a phosphor and a light-transmissive material such as aluminum oxide. Also, for example, it may be possible to use a ceramic that is formed by sintering powder of a phosphor and substantially consists of the phosphor.

The main material of the reflective portion 43 is, for example, a ceramic. Examples of the ceramic to be used as the main material include aluminum oxide, aluminum nitride, silicon oxide, yttrium oxide, zirconium oxide, and magnesium oxide. The reflective portion 43 is formed using, for example, a ceramic as the main material. Also, for example, the reflective portion 43 is a sintered body.

The wavelength conversion member 40 can be formed by, for example, integrally sintering the wavelength conversion portion 41 and the reflective portion 43. Note that the main material of the reflective portion 43 is not necessarily a ceramic. For example, the reflective portion 43 can be constituted of a metal film containing a metal as the main material, or a dielectric multilayer film formed by stacking dielectric layers to form a multilayer. Examples of the metal to be used as the main material include silver and aluminum. Also, the dielectric layers can be formed using, for example, silicon oxide, niobium oxide, aluminum oxide, aluminum nitride, titanium oxide, or tantalum oxide.

### (Reflective film 50)

The reflective film 50 is provided, at least, in a region of a part of the light incident surface of the wavelength conversion member 40. The reflective film 50 is provided, at least, in a region of the light incident surface above a predetermined position. For example, the predetermined position is above the middle point of the width of the light incident surface in the up-and-down direction. By the region where the reflective film 50 is provided, a region of the light incident surface where the reflective film 50 is not provided is spaced from the light-emitting surface.

The reflective film 50 is formed using a main material that is different from the main material forming the reflective portion 43 of the wavelength conversion member 40. The reflective film 50 is formed using a material that is different from the material used for the reflective portion 43 of the wavelength conversion member 40. For example, the reflective film 50 can be constituted of a metal film containing a metal as the main material, or a dielectric multilayer film formed by stacking dielectric layers as a multilayer. Examples of the metal to be used as the main material include silver and aluminum. Also, the dielectric layers can be formed using, for example, silicon oxide, niobium oxide, aluminum oxide, aluminum nitride, titanium oxide, or tantalum oxide.

Next, the light-emitting device 1 including the above-described components will be described.

### (Light-emitting device 1)

In the light-emitting device 1, the semiconductor laser element 20 is disposed in the inner space of the package 10. The semiconductor laser element 20 is disposed in the base portion 14 of the package 10. The semiconductor laser element 20 is disposed in the disposition region of the package 10.

The semiconductor laser element 20 emits laterally traveling light from the emission end surface. The semiconductor laser element 20 emits light traveling in the first direction from the emission end surface. The light that is emitted from the semiconductor laser element 20 and travels along the optical axis can be the light traveling in the first direction. In the light-emitting device as illustrated, the first direction is the same direction as the positive X-direction.

The semiconductor laser element 20 is mounted in the package 10 via the submount 30. The submount 30 is bonded to the upper surface (disposition region) of the package 10, and the semiconductor laser element 20 is disposed on the submount 30. By including the submount 30, a light-emission point of the semiconductor laser element 20 can be made high.

In the light-emitting device 1, the wavelength conversion member 40 is disposed in the inner space of the package 10. The wavelength conversion member 40 is disposed in the disposition region of the package 10. The wavelength conversion member 40 is disposed at a position away, in the first direction, from a position at which the semiconductor laser element 20 is disposed. The wavelength conversion member 40 is disposed such that the light incident surface is oriented to face the emission end surface of the semiconductor laser element 20.

In a plan view perpendicular to the light-emitting surface of the wavelength conversion portion 41, a region of at least 80% or more of the light incident surface of the wavelength conversion portion 41 overlaps an imaginary line that passes through the point of the light-emitting surface closest to the semiconductor laser element 20 and is parallel to the second direction. Note that the second direction is a perpendicular direction to the first direction in the plan view perpendicular to the light-emitting surface of the wavelength conversion portion 41. In the light-emitting device as illustrated, the second direction is the same direction as the Y direction.

The semiconductor laser element 20 emits light traveling from the light-emitting surface toward the wavelength conversion member 40. The light emitted from the semiconductor laser element 20 is incident on the light incident surface. In the light incident surface, a main portion of the light emitted from the semiconductor laser element 20 is included in the outer edge of the light incident surface. The main portion of the light emitted from the semiconductor laser element 20 is emitted to a region of the light incident surface that is not provided with the reflective film 50. The wavelength conversion portion 41 emits light converted in wavelength based on the light emitted from the semiconductor laser element 20. The wavelength conversion portion 41 emits the light converted in wavelength from the light-emitting surface.

The light incident surface of the wavelength conversion member 40 has such a shape that the maximum width thereof in a third direction is larger than the maximum width thereof in the second direction. On a plane perpendicular to the first direction, the main portion of the light emitted from the semiconductor laser element 20 preferably has such a shape that is longer in the third direction than in the second direction. Note that the second direction and the third direction are orthogonal to each other. In the light-emitting device as illustrated, the third direction is the same direction as the Z direction. For example, the fast axis direction of the FFP of the light emitted from the semiconductor laser element 20 is set to the same direction as the third direction, and the slow axis direction thereof is set to the same direction as the second direction. Thereby, it is possible to suppress emission of the light from the light incident surface of the wavelength conversion portion 41, and efficiently output light from the light-emitting surface of the wavelength conversion member 40.

Note that the light incident surface of the wavelength conversion member 40 may have such a shape that the maximum width thereof in the third direction is smaller than the maximum width thereof in the second direction. Adjustment of such a shape is possible by, for example, adjusting the length of the wavelength conversion member 40 in the third direction or adjusting the size of the light-emitting surface. In this case, on a plane perpendicular to the first direction, the main portion of the light emitted from the semiconductor laser element 20 preferably has a shape that is longer in the second direction than in the third direction. For example, the fast axis direction of the FFP of the light emitted from the semiconductor laser element 20 is set to the same direction as the second direction, and the slow axis direction thereof is set to the same direction as the third direction. Thereby, it is possible to suppress emission of the light from the light incident surface of the wavelength conversion portion 41, and efficiently output light from the light-emitting surface of the wavelength conversion member 40.

From the light-emitting surface of the wavelength conversion member 40, the light from the semiconductor laser element 20 or the light converted in wavelength by the wavelength conversion portion 41 is emitted. Although it is possible to emit only the light converted in wavelength from the light-emitting surface, for example, it is also possible to emit white light by emitting the blue light emitted from the semiconductor laser element 20 in combination with yellow fluorescent light emitted from the phosphor contained in the wavelength conversion portion 41.

The light emitted from the light-emitting surface of the wavelength conversion member 40 passes through the package 10, and is emitted to the exterior of the package 10. The light emitted from the light-emitting surface of the wavelength conversion member 40 passes through the cover portion 17 of the package 10, and is emitted upward. In this way, when the wavelength conversion member having the light incident surface at the lateral surface thereof and the light-emitting surface at the upper surface thereof is used, the number of parts can be reduced as compared with a configuration including a mirror and a wavelength conversion member. Also, the production process thereof can be simplified as compared with a production process including mounting the mirror in a package and mounting the wavelength conversion member on the package. Also, the light-emitting device can be produced at a lower cost.

Also, because the semiconductor laser element 20 emits light laterally, it is possible to produce the light-emitting device having a structure in which the laser beam from the semiconductor laser element 20 is not directly emitted from the cover portion 17 of the package 10. Therefore, safety of the light-emitting device utilizing the laser beam can be enhanced.

The shape of the outer edge of the upper surface of the reflective portion 43 is, in a plan view perpendicular to the upper surface, a shape having a second region that is constant in width in the second direction from the point closest to the semiconductor laser element 20 toward the first direction.

The reflective portion 43 reflects: the light emitted from the semiconductor laser element 20 and incident on the wavelength conversion portion 41; and the light converted in wavelength by the wavelength conversion portion 41. In a region of the wavelength conversion portion 41 that is covered with the reflective portion 43, the light incident on the reflective portion 43 from the wavelength conversion portion 41 is reflected by the reflective portion 43 and returned back to the wavelength conversion portion 41. This suppresses emission of the light from the region other than the light incident surface or the light-emitting surface, and efficiently outputs the light from the light-emitting surface.

The reflective film 50 reflects the light emitted from the semiconductor laser element 20 and incident on the wavelength conversion portion 41, and the light converted in wavelength by the wavelength conversion portion 41. In a reflective film 50-covered region of the light incident surface of the wavelength conversion portion 41, the light incident on the reflective film 50 from the wavelength conversion portion 41 is reflected by the reflective portion 50, and returned back to the wavelength conversion portion 41. This suppresses emission of the light from the light incident surface, and efficiently outputs the light from the light-emitting surface.

In the light-emitting device 1, in a direction perpendicular to the lower surface of the package 10, the length from the upper surface of the semiconductor laser element 20 to the lower surface of the cover portion 17 of the package 10 is smaller than the width of the wavelength conversion member 40. By satisfying such a condition, even if the wavelength conversion member 40 mounted in the package 10 becomes detached from the package 10, it is possible to restrict a movable range of the wavelength conversion member 40, and contribute to increase in safety of the light-emitting device 1.

The package 10 includes a light-shielding portion configured to shield light having the same wavelength range as the wavelength range of the light emitted from the semiconductor laser element 20. Also, the package 10 includes a light transmissive portion configured to transmit therethrough the light emitted from the light-emitting surface of the wavelength conversion member 40 and emit the light to the exterior. For example, the light-shielding portion is provided at the frame portion 15 of the package 10. Also, for example, the light transmissive portion is provided at the cover portion 17 of the package 10.

In the light-emitting device 1, the light-shielding portion is not necessarily disposed on an extension of an optical path through which the main portion of the light emitted from the emission end surface of the semiconductor laser element 20 is emitted from the emission end surface toward the uppermost point and incident on the wavelength conversion member 40.

In the light-emitting device 1, the light transmissive portion may be disposed on an extension of an optical path through which the main portion of the light is emitted from the emission end surface of the semiconductor laser element 20 toward the uppermost point and incident on the wavelength conversion member 40, and on a line segment before intersection between the extension and the light-shielding portion.

In the light-emitting device 1, the cover portion 17 of the package 10 is provided, at the upper or lower surface of the cover portion 17, with the light-shielding film surrounding the light transmissive portion. The light-shielding film is provided, at the upper or lower surface of the cover portion 17, over the entire region excluding the light transmissive portion. Thereby, it is possible to emit light from a desired region of the package 10, and suppress emission of light from the other region. Note that, in the light-emitting device 1 as illustrated, the light-shielding film is provided on the lower surface of the cover portion 17.

In the light-emitting device 1, in a top view, the light-emitting surface of the wavelength conversion portion 41 does not overlap the light-shielding film of the cover portion 17. In the light-emitting device 1, in a top view, the upper surface of the reflective portion 43 partially overlaps the light-shielding film of the cover portion 17. In the light-emitting device 1, in a top view, the outer edge of the wavelength conversion member 40 partially overlaps the light-shielding film of the cover portion 17. Note that, in the light-emitting device 1, in a top view, the outer edge of the wavelength conversion member 40 may entirely overlap the light-shielding film of the cover portion 17. Alternatively, in the light-emitting device 1, in a top view, the outer edge of the wavelength conversion member 40 does not necessarily entirely overlap the light-shielding film of the cover portion 17.

Here, as examples of the wavelength conversion member 40 included in the light-emitting device 1, a wavelength conversion member 40A to a wavelength conversion member 40G will be described. Also, the light-emitting device 1 including the wavelength conversion member 40 of each of the examples will be described. Note that, in each of the drawings illustrating the perspective views of the wavelength conversion member 40A to the wavelength conversion member 40G, the region indicated with hatching of dashed lines is a region where the reflective film 50 is to be provided.

### (Light-emitting device 1 including wavelength conversion member 40A)

FIG. 3A to FIG. 3D are drawings in relation to the wavelength conversion member 40A. In a plan view perpendicular to the light-emitting surface, the light-emitting surface of the wavelength conversion portion 41 has a shape having a first region increasing in width in the second direction from the side closest to the semiconductor laser element 20 toward the first direction. Adjusting the shape of the light-emitting surface can adjust a distribution of the light emitted from the light-emitting device. Also, the light-emitting surface of the wavelength conversion portion 41 is a pentagonal shape. Also, the light-emitting surface of the wavelength conversion portion 41 is a shape formed by cutting one corner of a quadrangle. This corner is located the closest to the semiconductor laser element 20 among the four corners, and a side formed through the cutting is in parallel to the second direction. Note that, in the wavelength conversion member 40A as illustrated, the first direction is the same direction as the positive X-direction.

The maximum width in the second direction of the light incident surface of the wavelength conversion portion 41 is the same as the minimum width in the second direction in the first region of the light-emitting surface of the wavelength conversion portion 41.

The maximum width in the second direction of the light incident surface of the wavelength conversion portion 41 is smaller than the maximum width in the second direction in the first region of the light-emitting surface of the wavelength conversion portion 41.

At a position that passes through a point at which the light lying along the optical axis from the semiconductor laser element 20 is incident on the light incident surface of the wavelength conversion portion 41, the width in the second direction of the light incident surface of the wavelength conversion portion 41 is the same as the minimum width in the second direction in the first region of the light-emitting surface of the wavelength conversion portion 41.

The minimum width in the second direction of the light incident surface of the wavelength conversion portion 41 is the same as the minimum width in the second direction in the first region of the light-emitting surface of the wavelength conversion portion 41. In the wavelength conversion member 40A, the light incident surface has a shape that is narrow in the second direction, and the light-emitting surface can have a larger shape than the light incident surface. Therefore, it is possible to efficiently emit light from the light-emitting surface.

In a plan view perpendicular to the light-emitting surface of the wavelength conversion portion 41, a region of at least 80% or more of the light incident surface of the wavelength conversion portion 41 overlaps the outer edge of the light-emitting surface. Also, in a plan view perpendicular to the light-emitting surface of the wavelength conversion portion 41, a region of at least 80% or more of the light incident surface of the wavelength conversion portion 41 overlaps the outer edge of the first region. Such a shape can be simply formed by, for example, using a polygonal columnar wavelength conversion member including a wavelength conversion portion and a reflective portion surrounding the entire lateral surface of the wavelength conversion portion, and dicing the polygonal columnar wavelength conversion member along a line passing through a part of the wavelength conversion portion from the lower surface thereof to the upper surface thereof.

In the light incident surface of the wavelength conversion portion 41, the reflective film 50 is not provided in a region below a predetermined position. Also, the predetermined position is above a position at which the main portion of the light emitted from the semiconductor laser element 20 is incident on the light incident surface.

### (Light-emitting device 1 including wavelength conversion member 40B)

FIG. 4A to FIG. 4D are drawings in relation to the wavelength conversion member 40B. In a plan view perpendicular to the light-emitting surface, the light-emitting surface of the wavelength conversion portion 41 has a shape having a first region increasing in width in the second direction from the side closest to the semiconductor laser element 20 toward the first direction. Adjusting the shape of the light-emitting surface can adjust a distribution of the light emitted from the light-emitting device. Also, the light-emitting surface of the wavelength conversion portion 41 is a quadrangular shape. Also, the light-emitting surface of the wavelength conversion portion 41 is a shape formed by cutting one corner of a triangle. This corner is located the closest to the semiconductor laser element 20 in the three corners, and a side formed through the cutting is in parallel to the second direction. Note that, in the wavelength conversion member 40B as illustrated, the first direction is the same direction as the positive X-direction.

The maximum width in the second direction of the light incident surface of the wavelength conversion portion 41 is the same as the minimum width in the second direction in the first region of the light-emitting surface of the wavelength conversion portion 41.

The maximum width in the second direction of the light incident surface of the wavelength conversion portion 41 is smaller than the maximum width in the second direction in the first region of the light-emitting surface of the wavelength conversion portion 41.

At a position that passes through a point at which the light lying along the optical axis from the semiconductor laser element 20 is incident on the light incident surface of the wavelength conversion portion 41, the width in the second direction of the light incident surface of the wavelength conversion portion 41 is the same as the minimum width in the second direction in the first region of the light-emitting surface of the wavelength conversion portion 41.

The minimum width in the second direction of the light incident surface of the wavelength conversion portion 41 is the same as the minimum width in the second direction in the first region of the light-emitting surface of the wavelength conversion portion 41. In the wavelength conversion member 40B, the light incident surface has a shape that is narrow in the second direction, and the light-emitting surface can have a larger shape than the light incident surface. Therefore, it is possible to efficiently emit light from the light-emitting surface.

In a plan view perpendicular to the light-emitting surface of the wavelength conversion portion 41, a region of at least 80% or more of the light incident surface of the wavelength conversion portion 41 overlaps the outer edge of the light-emitting surface. Also, in a plan view perpendicular to the light-emitting surface of the wavelength conversion portion 41, a region of at least 80% or more of the light incident surface of the wavelength conversion portion 41 overlaps the outer edge of the first region. Such a shape can be simply formed by, for example, using a polygonal columnar wavelength conversion member including a wavelength conversion portion and a reflective portion surrounding the entire lateral surface of the wavelength conversion portion, and dicing the polygonal columnar wavelength conversion member along a line passing through a part of the wavelength conversion portion from the lower surface thereof to the upper surface thereof.

In the light incident surface of the wavelength conversion portion 41, the reflective film 50 is not provided in a region below a predetermined position. Also, the predetermined position is above a position at which the main portion of the light emitted from the semiconductor laser element 20 is incident on the light incident surface.

### (Light-emitting device 1 including wavelength conversion member 40C)

FIG. 5A to FIG. 5D are drawings in relation to the wavelength conversion member 40C. In a plan view perpendicular to the light-emitting surface, the light-emitting surface of the wavelength conversion portion 41 has a shape having a first region increasing in width in the second direction from the side closest to the semiconductor laser element 20 toward the first direction. Adjusting the shape of the light-emitting surface can adjust a distribution of the light emitted from the light-emitting device. Also, the light-emitting surface of the wavelength conversion portion 41 is a quadrangular shape. Also, the light-emitting surface of the wavelength conversion portion 41 is a shape formed by cutting one corner of a triangle. This corner is located the closest to the semiconductor laser element 20 in the three corners, and a side formed through the cutting is in parallel to the second direction. Note that, in the wavelength conversion member 40C as illustrated, the first direction is the same direction as the positive X-direction.

The maximum width in the second direction of the light incident surface of the wavelength conversion portion 41 is larger than the minimum width in the second direction in the first region of the light-emitting surface of the wavelength conversion portion 41.

The maximum width in the second direction of the light incident surface of the wavelength conversion portion 41 is smaller than the maximum width in the second direction in the first region of the light-emitting surface of the wavelength conversion portion 41.

At a position that passes through a point at which the light lying along the optical axis from the semiconductor laser element 20 is incident on the light incident surface of the wavelength conversion portion 41, the width in the second direction of the light incident surface of the wavelength conversion portion 41 is larger than the minimum width in the second direction in the first region of the light-emitting surface of the wavelength conversion portion 41.

The minimum width in the second direction of the light incident surface of the wavelength conversion portion 41 is the same as the minimum width in the second direction in the first region of the light-emitting surface of the wavelength conversion portion 41. In the wavelength conversion member 40C, the light incident surface has a shape that is narrow in the second direction, and the light-emitting surface can have a larger shape than the light incident surface. Therefore, it is possible to efficiently emit light from the light-emitting surface. Also, because the lower surface of the wavelength conversion portion 41 is larger than the light-emitting surface, even if the light-emitting surface has the same size, it is possible to increase the quantity of light to be converted in wavelength as compared with the wavelength conversion portion 41 in which the lower surface has the same size as the light-emitting surface.

The wavelength conversion member 40C can be simply formed by, for example, using a polygonal columnar wavelength conversion member including a wavelength conversion portion and a reflective portion surrounding the entire lateral surface of the wavelength conversion portion, and dicing the polygonal columnar wavelength conversion member along a line passing through a part of the wavelength conversion portion from the lower surface thereof to the upper surface thereof.

In the light incident surface of the wavelength conversion portion 41, the reflective film 50 is not provided in a region below a predetermined position. Also, the predetermined position is above a position at which the main portion of the light emitted from the semiconductor laser element 20 is incident on the light incident surface.

### (Light-emitting device 1 including wavelength conversion member 40D)

FIG. 6A to FIG. 6D are drawings in relation to the wavelength conversion member 40D. In a plan view perpendicular to the light-emitting surface, the light-emitting surface of the wavelength conversion portion 41 has a shape having a first region that is constant in width in the second direction from the side closest to the semiconductor laser element 20 toward the first direction. Adjusting the shape of the light-emitting surface can adjust a distribution of the light emitted from the light-emitting device. Also, the light-emitting surface of the wavelength conversion portion 41 is a quadrangular shape. Note that, in the wavelength conversion member 40D as illustrated, the first direction is the same direction as the positive X-direction.

The maximum width in the second direction of the light incident surface of the wavelength conversion portion 41 is the same as the minimum width in the second direction in the first region of the light-emitting surface of the wavelength conversion portion 41.

The maximum width in the second direction of the light incident surface of the wavelength conversion portion 41 is the same as the maximum width in the second direction in the first region of the light-emitting surface of the wavelength conversion portion 41.

At a position that passes through a point at which the light lying along the optical axis from the semiconductor laser element 20 is incident on the light incident surface of the wavelength conversion portion 41, the width in the second direction of the light incident surface of the wavelength conversion portion 41 is the same as the minimum width in the second direction in the first region of the light-emitting surface of the wavelength conversion portion 41.

The minimum width in the second direction of the light incident surface of the wavelength conversion portion 41 is the same as the minimum width in the second direction in the first region of the light-emitting surface of the wavelength conversion portion 41.

In a plan view perpendicular to the light-emitting surface of the wavelength conversion portion 41, a region of at least 80% or more of the light incident surface of the wavelength conversion portion 41 overlaps the outer edge of the light-emitting surface. Also, in a plan view perpendicular to the light-emitting surface of the wavelength conversion portion 41, a region of at least 80% or more of the light incident surface of the wavelength conversion portion 41 overlaps the outer edge of the first region. Such a shape can be simply formed by, for example, using a polygonal columnar wavelength conversion member including a wavelength conversion portion and a reflective portion surrounding the entire lateral surface of the wavelength conversion portion, and dicing the polygonal columnar wavelength conversion member along a line passing through a part of the wavelength conversion portion from the lower surface thereof to the upper surface thereof.

In the light incident surface of the wavelength conversion portion 41, the reflective film 50 is also provided in a region below a predetermined position. Also, the predetermined position is above a position at which the main portion of the light emitted from the semiconductor laser element 20 is incident on the light incident surface. In the light incident surface of the wavelength conversion portion 41, the reflective film 50 is provided in regions that are away in the second direction from a region of the light incident surface on which the main portion of the light emitted from the semiconductor laser element 20 is incident. Thereby, it is possible to increase the size of the wavelength conversion portion 41, and reduce the quantity of light emitted from the light incident surface.

### (Light-emitting device 1 including wavelength conversion member 40E)

FIG. 7A to FIG. 7D are drawings in relation to the wavelength conversion member 40E. In a plan view perpendicular to the light-emitting surface, the light-emitting surface of the wavelength conversion portion 41 has a shape having a first region that is constant in width in the second direction from the side closest to the semiconductor laser element 20 toward the first direction. Adjusting the shape of the light-emitting surface can adjust a distribution of the light emitted from the light-emitting device. Also, the light-emitting surface of the wavelength conversion portion 41 is a quadrangular shape. Note that, in the wavelength conversion member 40E as illustrated, the first direction is the same direction as the positive X-direction.

The maximum width in the second direction of the light incident surface of the wavelength conversion portion 41 is the same as the minimum width in the second direction in the first region of the light-emitting surface of the wavelength conversion portion 41.

The maximum width in the second direction of the light incident surface of the wavelength conversion portion 41 is the same as the maximum width in the second direction in the first region of the light-emitting surface of the wavelength conversion portion 41.

At a position that passes through a point at which the light lying along the optical axis from the semiconductor laser element 20 is incident on the light incident surface of the wavelength conversion portion 41, the width in the second direction of the light incident surface of the wavelength conversion portion 41 is smaller than the minimum width in the second direction in the first region of the light-emitting surface of the wavelength conversion portion 41.

The minimum width in the second direction of the light incident surface of the wavelength conversion portion 41 is smaller than the minimum width in the second direction in the first region of the light-emitting surface of the wavelength conversion portion 41. In the wavelength conversion member 40E, the width in the second direction in a region of the light incident surface on which the light from the semiconductor laser element 20 is incident is narrower than the width of the light-emitting surface in the second direction. Therefore, it is possible to efficiently emit light from the light-emitting surface.

In a plan view perpendicular to the light-emitting surface of the wavelength conversion portion 41, a region of at least 80% or more of the light incident surface of the wavelength conversion portion 41 overlaps the outer edge of the light-emitting surface. Also, in a plan view perpendicular to the light-emitting surface of the wavelength conversion portion 41, a region of at least 80% or more of the light incident surface of the wavelength conversion portion 41 overlaps the outer edge of the first region. Such a shape can be simply formed by, for example, using a polygonal columnar wavelength conversion member including a wavelength conversion portion and a reflective portion surrounding the entire lateral surface of the wavelength conversion portion, and dicing the polygonal columnar wavelength conversion member along a line passing through a part of the wavelength conversion portion from the lower surface thereof to the upper surface thereof.

In the light incident surface of the wavelength conversion portion 41, the reflective film 50 is not provided in a region below a predetermined position. Also, the predetermined position is above a position at which the main portion of the light emitted from the semiconductor laser element 20 is incident on the light incident surface.

### (Light-emitting device 1 including wavelength conversion member 40F)

FIG. 8A to FIG. 8D are drawings in relation to the wavelength conversion member 40F. In a plan view perpendicular to the light-emitting surface, the light-emitting surface of the wavelength conversion portion 41 has a shape having a first region that is constant in width in the second direction from the side closest to the semiconductor laser element 20 toward the first direction. Adjusting the shape of the light-emitting surface can adjust a distribution of the light emitted from the light-emitting device. Also, the light-emitting surface of the wavelength conversion portion 41 is a quadrangular shape. Note that, in the wavelength conversion member 40F as illustrated, the first direction is the same direction as the positive X-direction.

The maximum width in the second direction of the light incident surface of the wavelength conversion portion 41 is larger than the minimum width in the second direction in the first region of the light-emitting surface of the wavelength conversion portion 41.

The maximum width in the second direction of the light incident surface of the wavelength conversion portion 41 is larger than the maximum width in the second direction in the first region of the light-emitting surface of the wavelength conversion portion 41.

At a position that passes through a point at which the light lying along the optical axis from the semiconductor laser element 20 is incident on the light incident surface of the wavelength conversion portion 41, the width in the second direction of the light incident surface of the wavelength conversion portion 41 is larger than the minimum width in the second direction in the first region of the light-emitting surface of the wavelength conversion portion 41.

The minimum width in the second direction of the light incident surface of the wavelength conversion portion 41 is the same as the minimum width in the second direction in the first region of the light-emitting surface of the wavelength conversion portion 41. In the wavelength conversion member 40F, the light-emitting surface, in other words, a region from which light is emitted, is small. Also, because the lower surface of the wavelength conversion portion 41 is larger than the light-emitting surface, even if the light-emitting surface has the same size, it is possible to increase the quantity of light to be converted in wavelength as compared with the wavelength conversion portion 41 in which the lower surface has the same size as the light-emitting surface.

The wavelength conversion member 40F can be simply formed by, for example, using a polygonal columnar wavelength conversion member including a wavelength conversion portion and a reflective portion surrounding the entire lateral surface of the wavelength conversion portion, and dicing the polygonal columnar wavelength conversion member along a line passing through a part of the wavelength conversion portion from the lower surface thereof to the upper surface thereof.

In the light incident surface of the wavelength conversion portion 41, the reflective film 50 is provided in a region below a predetermined position. Also, the predetermined position is above a position at which the main portion of the light emitted from the semiconductor laser element 20 is incident on the light incident surface. In the light incident surface of the wavelength conversion portion 41, the reflective film 50 is provided in regions that are away in the second direction from a region of the light incident surface on which the main portion of the light emitted from the semiconductor laser element 20 is incident. Thereby, it is possible to increase the size of the wavelength conversion portion 41, and reduce the quantity of light emitted from the light incident surface.

### (Light-emitting device 1 including wavelength conversion member 40G)

FIG. 9A to FIG. 9D are drawings in relation to the wavelength conversion member 40G. In a plan view perpendicular to the light-emitting surface, the light-emitting surface of the wavelength conversion portion 41 has a shape having a first region decreasing in width in the second direction from the side closest to the semiconductor laser element 20 toward the first direction. Adjusting the shape of the light-emitting surface can adjust a distribution of the light emitted from the light-emitting device. Also, the light-emitting surface of the wavelength conversion portion 41 is a quadrangular shape. Note that, in the wavelength conversion member 40G as illustrated, the first direction is the same direction as the positive X-direction.

The maximum width in the second direction of the light incident surface of the wavelength conversion portion 41 is larger than the minimum width in the second direction in the first region of the light-emitting surface of the wavelength conversion portion 41.

The maximum width in the second direction of the light incident surface of the wavelength conversion portion 41 is the same as the maximum width in the second direction in the first region of the light-emitting surface of the wavelength conversion portion 41.

At a position that passes through a point at which the light lying along the optical axis from the semiconductor laser element 20 is incident on the light incident surface of the wavelength conversion portion 41, the width in the second direction of the light incident surface of the wavelength conversion portion 41 is larger than the minimum width in the second direction in the first region of the light-emitting surface of the wavelength conversion portion 41.

The minimum width in the second direction of the light incident surface of the wavelength conversion portion 41 is larger than the minimum width in the second direction in the first region of the light-emitting surface of the wavelength conversion portion 41. In the wavelength conversion member 40G, the reflective portion 43 readily reflects light in a direction toward the light-emitting surface. Therefore, it is possible to efficiently emit light from the light-emitting surface.

In a plan view perpendicular to the light-emitting surface of the wavelength conversion portion 41, a region of at least 80% or more of the light incident surface of the wavelength conversion portion 41 overlaps the outer edge of the light-emitting surface. Also, in a plan view perpendicular to the light-emitting surface of the wavelength conversion portion 41, a region of at least 80% or more of the light incident surface of the wavelength conversion portion 41 overlaps the outer edge of the first region. Such a shape can be simply formed by, for example, using a polygonal columnar wavelength conversion member including a wavelength conversion portion and a reflective portion surrounding the entire lateral surface of the wavelength conversion portion, and dicing the polygonal columnar wavelength conversion member along a line passing through a part of the wavelength conversion portion from the lower surface thereof to the upper surface thereof.

In the light incident surface of the wavelength conversion portion 41, the reflective film 50 is provided in a region below a predetermined position. Also, the predetermined position is above a position at which the main portion of the light emitted from the semiconductor laser element 20 is incident on the light incident surface. In the light incident surface of the wavelength conversion portion 41, the reflective film 50 is provided in regions that are away in the second direction from a region of the light incident surface on which the main portion of the light emitted from the semiconductor laser element 20 is incident. Thereby, it is possible to increase the size of the wavelength conversion portion 41, and reduce the quantity of light emitted from the light incident surface.

The light-emitting device described in each embodiment can be used in, for example, lighting equipment (e.g., smart lights and indirect lighting), automotive headlights, head mounted displays, projectors, and displays.

### Reference Sings List

- 1: light-emitting device
- 10: package
- 14: base portion
- 15: frame portion
- 17: cover portion
- 20: semiconductor laser element
- 30: submount
- 40: wavelength conversion member
- 41: wavelength conversion portion
- 42: lateral surface
- 42A: upper surface
- 42B: lower surface
- 43: reflective portion

## Claims

1. A light-emitting device comprising:
a semiconductor laser element (20);
a wavelength conversion member (40); and
a package (10); wherein:
the wavelength conversion member (40) comprises:
a wavelength conversion portion (41), and
a reflective portion (43);
the wavelength conversion portion (41) includes:
a light incident surface that is a lateral surface (42) of the wavelength conversion portion (41) on which light emitted from the semiconductor laser element (20) is incident, and
a light-emitting surface that is an upper surface (42A) of the wavelength conversion portion (41) from which light converted in wavelength is emitted, the light converted in wavelength being obtained by converting a wavelength of the light emitted from the semiconductor laser element (20);
the reflective portion (43) is provided on a surface of the wavelength conversion portion (41) that does not include the light incident surface and does not include the light-emitting surface (20), and the reflective portion (43) is configured to reflect:
the light emitted from the semiconductor laser element (20) and incident on the wavelength conversion portion (41), and
the light converted in wavelength by the wavelength conversion portion (41),
the package (10) includes a disposition region where the semiconductor laser element (20) and the wavelength conversion member (40) are disposed, and defines an inner space in which the semiconductor laser element (20) and the wavelength conversion member (40) are disposed;
the wavelength conversion member (40) is disposed at a position away in a first direction from a position at which the semiconductor laser element (20) is disposed;
in a plan view perpendicular to the light-emitting surface, the light-emitting surface has a shape that has a first region increasing in width in a second direction perpendicular to the first direction from a side closest to the semiconductor laser element (20) toward the first direction; and **characterized in that**
in the plan view perpendicular to the light-emitting surface, a region of at least 80% or more of the light incident surface overlaps an imaginary line that passes through a point of the light-emitting surface closest to the semiconductor laser element (20) and that is parallel to the second direction.

2. The light-emitting device according to claim 1, wherein a maximum width in the second direction of the light incident surface is the same as a minimum width in the second direction in the first region of the light-emitting surface.

3. The light-emitting device according to claim 1, wherein a maximum width of the light incident surface in the second direction is larger than a minimum width in the second direction in the first region of the light-emitting surface.

4. The light-emitting device according to claim 3, wherein a maximum width of the light incident surface in the second direction is smaller than a maximum width in the second direction in the first region of the light-emitting surface.

5. The light-emitting device according to any one of claims 1 to 4, further comprising a reflective film (50) that is provided only in a region of the light incident surface above a predetermined position, the reflective film (50) being configured to reflect the light from the semiconductor laser element (20) and the light converted in wavelength by the wavelength conversion portion (41), wherein a material from which the reflective film (50) is formed is different from a material from which the reflective portion (43) is formed.

6. The light-emitting device according to any one of claims 1 to 5, wherein the light incident surface and the light-emitting surface connect to each other at a surface of the wavelength conversion member (40).

## Patentansprüche

1. Lichtemittierende Vorrichtung, umfassend:
ein Halbleiterlaserelement (20);
ein Wellenlängenumwandlungsbauteil (40); und
eine Packung (10); wobei:
das Wellenlängenumwandlungsbauteil (40) umfasst:
einen Wellenlängenumwandlungsbereich (41), und
einen Reflektionsbereich (43);
wobei der Wellenlängenumwandlungsbereich (41) enthält:
eine Lichteinfallsoberfläche, die eine laterale Oberfläche (42) des Wellenlängenumwandlungsbereichs (41) ist, auf die Licht einfällt, das von dem Halbleiterlaserelement (20) emittiert wird, und
eine Lichtemissionsoberfläche, die eine obere Oberfläche (42A) des Wellenlängenumwandlungsbereichs (41) ist, von der Licht emittiert wird, das in der Wellenlänge umgewandelt ist, wobei das in der Wellenlänge umgewandelte Licht durch Umwandeln einer Wellenlänge des Lichts erhalten wird, das von dem Halbleiterlaserelement (20) emittiert wird;
wobei der Reflektionsbereich (43) auf einer Oberfläche des Wellenlängenumwandlungsbereichs (41) vorgesehen ist, die die Lichteinfallsoberfläche nicht enthält, und die die Lichtemissionsoberfläche (20) nicht enthält, und wobei der Reflektionsbereich (43) dazu konfiguriert ist, Folgendes zu reflektieren:
das Licht, das von dem Halbleiterlaserelement (20) emittiert wird und auf den Wellenlängenumwandlungsbereich (41) einfällt, und
das Licht, das in der Wellenlänge durch den Wellenlängenumwandlungsbereich (41) umgewandelt wird,
wobei die Packung (10) eine Anordnungsregion enthält, wo das Halbleiterlaserelement (20) und das Wellenlängenumwandlungsbauteil (40) angeordnet sind, und einen inneren Raum definiert, in dem das Halbleiterlaserelement (20) und das Wellenlängenumwandlungsbauteil (40) angeordnet sind;
wobei das Wellenlängenumwandlungsbauteil (40) an einer Position angeordnet ist, die in einer ersten Richtung von einer Position beabstandet ist, an der das Halbleiterlaserelement (20) angeordnet ist;
wobei die lichtemittierende Oberfläche in einer Draufsicht orthogonal zu der Lichtemissionsoberfläche eine Gestalt hat, die eine erste Region hat, die in der Breite in einer zweiten Richtung orthogonal zu der ersten Richtung von einer Seite am nächsten zu dem Halbleiterlaserelement (20) in Richtung der ersten Richtung zunimmt; und **dadurch gekennzeichnet, dass**
in der Draufsicht orthogonal zu der Lichtemissionsoberfläche, eine Region von wenigstens 80% oder mehr von der Lichteinfallsoberfläche mit einer imaginären Linie überlappt, die durch einen Punkt der Lichtemissionsoberfläche am nächsten zu dem Halbleiterlaserelement (20) verläuft und parallel zu der zweiten Richtung ist.

2. Lichtemittierende Vorrichtung nach Anspruch 1, wobei eine maximale Breite in der zweiten Richtung der Lichteinfallsoberfläche gleich einer minimalen Breite in der zweiten Richtung in der ersten Region der Lichtemissionsoberfläche ist.

3. Lichtemittierende Vorrichtung nach Anspruch 1, wobei eine maximale Breite der Lichteinfallsoberfläche in der zweiten Richtung größer ist als eine minimale Breite in der zweiten Richtung in der ersten Region der Lichtemissionsoberfläche.

4. Lichtemittierende Vorrichtung nach Anspruch 3, wobei eine maximale Breite der Lichteinfallsoberfläche in der zweiten Richtung kleiner ist als eine maximale Breite in der zweiten Richtung in der ersten Region der Lichtemissionsoberfläche.

5. Lichtemittierende Vorrichtung nach einem der Ansprüche 1 bis 4, ferner umfassend einen Reflektionsfilm (50), der nur in einer Region der Lichteinfallsoberfläche über einer vorbestimmten Position vorgesehen ist, wobei der Reflektionsfilm (50) dazu konfiguriert ist, das Licht von dem Halbleiterlaserelement (20) und das Licht, das in der Wellenlänge durch den Wellenlängenumwandlungsbereich (41) umgewandelt ist, zu reflektieren, wobei ein Material, aus dem der Reflektionsfilm (50) gebildet ist, von einem Material verschieden ist, aus dem der Reflektionsbereich (43) gebildet ist.

6. Lichtemittierende Vorrichtung nach einem der Ansprüche 1 bis 5, wobei die Lichteinfallsoberfläche und die Lichtemissionsoberfläche an einer Oberfläche des Wellenlängenumwandlungsbauteils (40) miteinander verbunden sind.

## Revendications

1. Un dispositif d'émission de lumière comprenant :
un élément laser (20) à semi-conducteur ;
un élément (40) de conversion de longueur d'onde ; et
un boîtier (10) ; dans lequel :
l'élément (40) de conversion de longueur d'onde comprend :
une partie (41) de conversion de longueur d'onde, et
une partie réfléchissante (43) ;
la partie (41) de conversion de longueur d'onde comprend :
une surface d'incidence de lumière qui est une surface latérale (42) de la partie (41) de conversion de longueur d'onde, sur laquelle la lumière émise par l'élément laser (20) à semi-conducteur est incidente, et
une surface d'émission de lumière qui est une surface supérieure (42A) de la partie (41) de conversion de longueur d'onde, à partir de laquelle la lumière convertie en longueur d'onde est émise, la lumière convertie en longueur d'onde étant obtenue en convertissant une longueur d'onde de la lumière émise par l'élément laser (20) à semi-conducteur ;
la partie réfléchissante (43) est agencée sur une surface de la partie (41) de conversion de longueur d'onde, qui n'inclut pas la surface d'incidence de lumière et n'inclut pas la surface (20) d'émission de lumière, et la partie réfléchissante (43) est configurée pour réfléchir :
la lumière émise par l'élément laser (20) à semi-conducteur et incidente sur la partie (41) de conversion de longueur d'onde, et
la lumière convertie en longueur d'onde par la partie (41) de conversion de longueur d'onde,
le boîtier (10) comprend une zone de disposition où l'élément laser (20) à semi-conducteur et l'élément (40) de conversion de longueur d'onde sont agencés, et définit un espace intérieur dans lequel l'élément laser (20) à semi-conducteur et l'élément (40) de conversion de longueur d'onde sont disposés ;
l'élément (40) de conversion de longueur d'onde est disposé en une position éloignée dans une première direction d'une position dans laquelle l'élément laser (20) à semi-conducteur est disposé ;
dans une vue en plan perpendiculaire à la surface d'émission de lumière, la surface d'émission de lumière a une forme qui a une première zone dont la largeur augmente dans une deuxième direction perpendiculaire à la première direction depuis un côté le plus proche de l'élément laser (20) à semi-conducteur vers la première direction ; et **caractérisé en ce que**
dans la vue en plan perpendiculaire à la surface d'émission de lumière, une zone d'au moins 80 % ou plus de la surface d'incidence de lumière chevauche une ligne imaginaire qui passe par un point de la surface d'émission de lumière le plus proche de l'élément laser (20) à semi-conducteur et qui est parallèle à la deuxième direction.

2. Le dispositif d'émission de lumière selon la revendication 1, dans lequel une largeur maximale dans la deuxième direction de la surface d'incidence de lumière est la même qu'une largeur minimale dans la deuxième direction dans la première zone de la surface d'émission de lumière.

3. Le dispositif d'émission de lumière selon la revendication 1, dans lequel une largeur maximale de la surface d'incidence de lumière dans la deuxième direction est supérieure à une largeur minimale dans la deuxième direction dans la première zone de la surface d'émission de lumière.

4. Le dispositif d'émission de lumière selon la revendication 3, dans lequel une largeur maximale de la surface d'incidence de lumière dans la deuxième direction est inférieure à une largeur maximale dans la deuxième direction dans la première zone de la surface d'émission de lumière.

5. Le dispositif d'émission de lumière selon l'une quelconque des revendications 1 à 4, comprenant en outre un film réfléchissant (50) qui est placé uniquement dans une zone de la surface d'incidence de lumière au-dessus d'une position prédéterminée, le film réfléchissant (50) étant configuré pour réfléchir la lumière provenant de l'élément laser (20) à semi-conducteur et la lumière convertie en longueur d'onde par la partie (41) de conversion de longueur d'onde, un matériau à partir duquel le film réfléchissant (50) est formé étant différent d'un matériau à partir duquel la partie réfléchissante (43) est formée.

6. Le dispositif d'émission de lumière selon l'une quelconque des revendications 1 à 5, dans lequel la surface d'incidence de lumière et la surface d'émission de lumière se connectent l'une à l'autre au niveau d'une surface de l'élément (40) de conversion de longueur d'onde.
